# EUROPEAN PATENT APPLICATION

(11) **EP 2 421 038 A1**
(43) Date of publication of application: **22.02.2012**
(21) Application number: 09842857.6
(22) Date of filing: 10.04.2009
(51) Int. Cl.: H01L 25/075, H01L 25/13, H01L 23/367, H01L 33/00

(54) **RADIATION SUBSTRATE FOR POWER LED AND POWER LED PRODUCTION AND MANUFACTURING METHOD THEREOF**

(71) Applicant: Foshan Nationstar Optoelectronics Co., Ltd, Guangdong 528000 (CN)
(72) Inventor: YU, Binhai, Guangdong 528000 (CN); LI, Junzheng, Guangdong 528000 (CN); XIA, Xunli, Guangdong 528000 (CN)
(74) Representative: Gulde Hengelhaupt Ziebig & Schneider
(86) International application number: PCT/CN2009/000388
(87) International publication number: WO 2010/115296

(57) **Abstract**

The present invention provides manufacturing methods for a power LED substrate with a mounting hole and a heat sink and for its power LED product and products thereof. The disclosed fabrication methods for power LED heat-dissipating substrate include the following steps a) selecting substrate material and processing; b) fabricating heat sink; c) assembling substrate and heat sink. The manufacturing methods of power LED products are based upon the manufacturing methods for heat-dissipating substrate, including the following steps: mounting LED die, bonding wire, packaging, post hardening, separating components, testing, classifying, and taping.

## Description

### FIELD OF THE INVENTION

This invention relates to the field of manufacturing method for power LED heat-dissipating substrate and for its power LED product and products thereof. More specifically, the invention relates to methods for fabrication of a power LED having a heat-dissipating substrate that includes a heat sink and a mounting hole adapted to receive the heat sink and of its power LED product and the products thereof.

### BACKGROUND OF THE INVENTION

Power LEDs have many advantages that include small size, long lifetime, low driving voltage, low consumption of electric power, fast reaction, excellent shock resistance, etc. Thus, there is a trend for replacing traditional light source with the power LEDs. Power LED packaging mainly involves optical, thermal, electrical, and structural aspects, as well as fabrication technique. Especially for high power LED, heat dissipation is an important factor that affects efficiency and lifetime of the power LED. Currently, the power LED has an approximately 15% conversion efficiency for electrical power to optical power, the remaining 85% of electrical power converts to thermal energy. Furthermore, white LED does not include infrared such that heat may not release in the form of radiation. If a LED die does not efficiently release heat, the LED die may get heated and result in non-uniform thermal stress such that the conversion efficiency and fluoresce irradiation efficiency will be reduced. When temperature exceeds a threshold, the inefficiency of a LED component exponentially increases. For a temperature increase of 2°C, reliability of the LED component decreases 10%. For example, near room temperature, LED light emission decreases about 1% for an environmental temperature increase of 1°C. When the LED component exposes to an environmental temperature of 20°C, light brightness may reduce by 35%. Therefore, it is a key issue to resolve heat dissipation for packaging power LED. However, there are still problems such as complex manufacturing method and high cost in the present fabrication of power LED. Lead frame and ceramic substrate are commonly used in the power LED fabrication.

The fabrication based on lead frame techniques includes 1) forming metal trace frame; 2) adding heat sink to the metal trace frame; 3) forming cavity over the metal trace frame by encapsulating white or black glue to place electrode wire and heat sink in fixed positions. 4) mounting die on the heat sink; 5) bonding wire; 6) mounting optical lens on the frame; 7) injecting encapsulation colloid; 8) hardening; 9) separating. However, such fabrication method has complicated technique, low yield, and high product cost. The packaging structure does not allow automated tests and taping, and is difficult for mounting on a circuit by using a surface mount technique of high yield, thus is not suitable for large-scale production.

The fabrication method for power LED based upon ceramic substrate includes the following steps: 1) forming metal traces on the ceramic substrate by low temperature sintering, where the ceramic substrate helps heat dissipation, and the metal traces conducts electricity; 2) mounting a metalic reflective cavity on the ceramic substrate; 3) mounting die inside the metallic reflective cavity on the ceramic substrate; 4) bonding wire; and 5) mounting optical lens inside the metallic reflective cavity. However, fabrication of the ceramic substrate is complicated, difficult and expensive. Although the ceramic substrate has good insulation, a common ceramic substrate, such as aluminum nitride, has poor thermal conductivity. The aluminum nitride has a thermal conductivity of about 24 W/m.k, is only sixteenth of the thermal conductivity of copper. When the LED component has a high power, especially the component power exceeds 5W, heat dissipation of the LED component is not ideal.

To reduce production cost, a method for mounting heat sink on a circuit board is proposed for power LED, for example, in PCT Patent Publication No. WO2006104325. The method includes the main steps: 1) forming multilayer circuit board; 2) drilling through-hole in each circuit layer; 3) connecting multilayer circuit board having through-holes, overlapping the through-holes for each layer with corresponding layers such that the through-hole in each layer overlaps with the other layers to form a cavity; 4) placing a heat sink inside the cavity of the multilayer circuit. However, such overlapping mounting requires welding and very high accuracy for positioning. Furthermore, the multilayer circuit board may have issues with false welding or uneven welding. The fabrication cost and complexity in processing obviously increase such that production yield is not high and it is hard to ensure product quality.

With respect to heat dissipation in LED component, there is also a method for forming a mounting hole in heat-dissipating substrate and placing a heat sink into the mounting hole. For example, patent publication CN1977399A discloses a method based upon mounting a heat sink in printed circuit board (PCB) to fabricate a LED substrate. The main steps include: 1) drilling through-hole in PCB, forming the through-hole in a cone structure; 2) fabricating a heat sink into the cone structure; 3) mounting the heat-dissipating piece into the through-hole in PCB. Such a method utilizes a thin heat-dissipating piece and provides relatively small heat dissipation, and is not suitable for high power LED components. Furthermore, such a fabrication method has some practical concerns. For example, bonding of heat sink to mounting hole is weak, and the heat sink is easy to fall off. Other problems include difficulty in positioning, poor reliability and heat dissipation. In addition, processing of the cone structure is complex. Thus, it is difficult to control consistency and to ensure quality.

The present techniques as described above still has problems in volume production of power LED, especially in production of high power LED, such as relatively complex structure, unstable product quality, and high production cost. Because of the structure formed in the fabrication technique is not suitable for automatic testing, taping, utilization of the product also requires mounting through welding, such that it is not convenient for testing power LED and mounting the LED for application, and it is difficult to meet the need of large-scale volume production.

Thus, there remains a need for developing methods for a simple fabrication technique with low production cost and good product quality, especially suitable for large-scale volume production and application of new type of power LED heat-dissipating substrates and power LED products, to meet the increasing market demand.

### BRIEF SUMMARY

The invention aims to overcome the above shortcomings in fabrication methods and products of power LED heat-dissipating substrate and power LED, particularly for high power LED. The shortcomings include high demand in fabrication technique, complex process flow, low production yield, high product cost, and poor heat dissipation. The power LED products also have high product cost, poor consistency and reliability, and inconvenience in testing and mounting LED. The invention provides a method for fabrication of heat-dissipating substrate by mounting a heat sink in PCB, a method for fabrication of power LED with the heat-dissipating substrate, and products based upon the fabrication methods according to the present invention.

In a first embodiment, the present invention provides a method of fabricating a heat-dissipating substrate for power LED, including the following steps:
a) Constructing a mounting hole on a circuit board, forming metal trace on the circuit board, which can sustain a mold clamping pressure and an injection pressure, as well as a continuous high temperature during molding process. The circuit board is made of materials of a high glass transition temperature and a shear resistance. The mounting hole includes a blind-hole of large diameter and a through-hole of small diameter, where the axial direction of blind-hole is the same as that of the through-hole;
b) Fabricating a heat sink using a thermal conductive material, forming a structure of a step cylinder comprising an upper step and a lower step, where the heat sink has shape and size matched to that of mounting hole in the circuit board;
c) Placing the heat sink into the mounting hole to form firm combination; Steps a) and b) may exchange operating sequence with each other or may occur simultaneously.

In a second embodiment, the present invention provides a method for fabricating power LED based upon a circuit board, including the method for fabrication of heat-dissipating substrate as described in the first embodiment. The method further includes the following steps:
After step c), bonding a LED die onto the heat sink on the circuit board by low temperature solidification; and connecting electrode of the LED die with metal trace on the circuit board.

In a third embodiment, the present invention provides a method for fabricating power LED based upon circuit board, includes the method for fabrication of the heat-dissipating substrate as described in the first embodiment. The method includes the following steps:
Step b) includes bonding the LED die onto the heat sink by high temperature solidification;
Step c) includes connecting electrode of the LED die with metal trace on the circuit board.

In a fourth embodiment, the present invention provides a heat-dissipating substrate as fabricated by using method according to the first embodiment.

In a fifth embodiment, the present invention provides power LED product as fabricated in the method according to the second embodiment or the third embodiment.

In a sixth embodiment, the present invention provides a light source, characterized by including power LED according to the fifth embodiment.

The disclosed method for fabrication of heat-dissipating substrate is simple, which reduces the demand for the present technology, and can efficiently resolve the heat dissipation problem for power LED components, particularly for high power LED.

The disclosed method for fabricating heat-dissipating substrate simplifies production processing of present power LED products. The product based upon the method of the present invention has very good consistency, high reliability, good heat dissipation, good light emitting, and low cost. In addition, the disclosed product allows to be automatically tested and taped, and to use surface mounting technique of high production yield on circuit board. Therefore, the method is very suitable for large-scale production, and thus ensures to meet the need of increasing marketing demand of power LED products.

In short, the method of the present invention greatly simplifies processing of heat-dissipating substrate of power LED and power LED products. The method provides high yield and low cost and can very well meet the need for high volume and low cost product of power LED. The method provides heat-dissipating substrate of power LED with good heat-dissipating result and enables to improve quality of power LED product. The power LED according to the method of the present invention has low cost and high quality, is easy for testing and mounting for application, and thus is suitable for large-scale production and various applications.

### BRIEF DESCRIPTION OF THE DRAWINGS

FIG. 1 is a flow chart illustrating steps for fabricating heat-dissipating substrate of power LED in an embodiment;

FIG. 2 is a simplified diagram for structure of the heat-dissipating substrate of FIG. 1 in a first embodiment.

FIG. 3 is a simplified diagram of heat sink and mounting hole for heat sink of FIG. 1.

FIG. 4 is a flow chart illustrating steps for fabricating heat-dissipating substrate of power LED in a second embodiment.

FIG. 5 is a simplified diagram for structure of the heat-dissipating substrate of FIG. 4.

FIG. 6 is a flow chart illustrating steps for fabricating power LED with heat-dissipating substrate fabricated using method of the first embodiment.

FIG. 7 is a simplified diagram for high power LED fabricated using method of FIG. 6.

FIG. 8 is a flow chart illustrating steps for fabricating power LED with heat-dissipating substrate fabricated using method of the second embodiment.

FIG. 9 is a simplified diagram of power strip light source with heat-dissipating substrate in an embodiment.

FIG. 10 is a simplified diagram of power strip light source with heat-dissipating substrate in an embodiment.

FIG. 11 is a simplified diagram of power strip light source with heat-dissipating substrate in an embodiment.

FIG. 12 is a simplified diagram of power surface light source with heat-dissipating substrate in an embodiment.

FIG. 13 is a simplified diagram of power surface light source with heat-dissipating substrate in an embodiment.

Labels in the figures:
1 circuit board; 2 mounting hole for heat sink: small hole 2a, large hole 2b; 3 metal trace: internal trace connection 3a, external trace connection 3b; 4 heat sink: upper step 4a and lower step 4b; 5 dividing slot 5a, dividing hole 5b; 6 cut position line; 7 LED die; 8 interconnection wire; 9 encapsulate.

### DETAILED DESCRIPTION

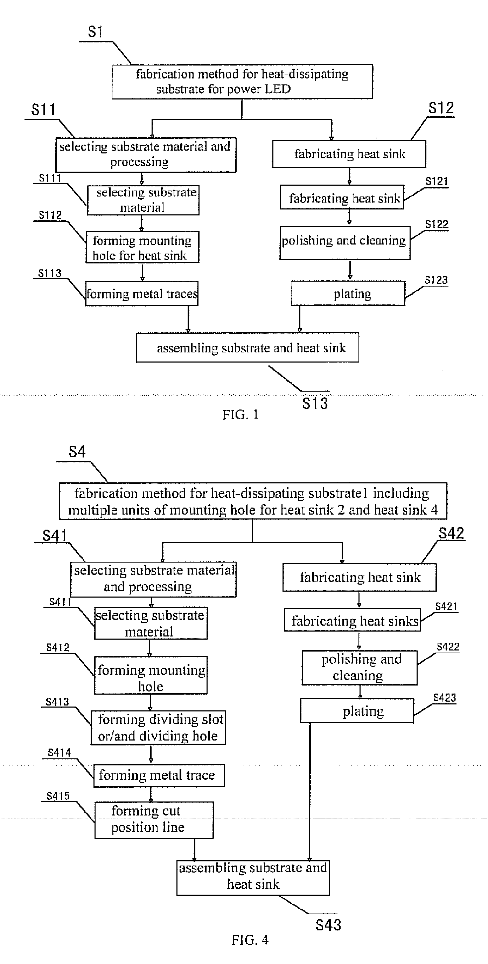

According to a first embodiment, the fabrication method of heat-dissipating substrate for power LED are illustrated in FIG. 1, FIG. 2, FIG. 3, FIG. 9, FIG. 10, FIG. 11, FIG. 12, and FIG. 13.

In an embodiment, (S1) fabrication method for heat-dissipating substrate for power LED includes the following steps: (S11) selecting substrate material and processing, (S12) fabricating heat sink, (S13) assembling substrate and heat sink. (S 11) selecting substrate material and processing and (S12) fabricating heat sink may exchange operating sequence or simultaneously occur.

As illustrated in FIG. 1, (S11) selecting substrate material and processing includes (S111) selecting substrate material, (S112) forming mounting hole for heat sink, and (S113) forming metal traces.

(S111) selecting substrate material: selected circuit board may be a single structure, a single side, double side or multilayer composite circuit board, preferably, a double side circuit board. The circuit board needs to sustain a mold clamping pressure and an injection pressure during product encapsulate. The circuit board also needs to sustain continuous high temperature during a molding process to ensure that the circuit board does not deform under the high temperature during product encapsulate. The circuit board also needs to have a glass transition temperature higher than the molding temperature and enough shear resistance. Generally, the circuit board needs to have a mold clamping pressure of 0-6 MPa, an injection pressure within 5-50 Mpa, to sustain a high molding temperature within 60-220°C for a molding time not exceeding 30 minutes, and to have a glass transition temperature of at least 120°C. When the product is cut, the heat-dissipating substrate still needs to have a shear resistance such that edge of the PCB after cutting still remains smooth and the PCB is able to be cut into PCB units of small areas. Substrate material (PCB board material) that can satisfy the above criteria may include paper-based substrate, resin fiberglass substrate, and composite substrate. Preferably, the substrate is a resin fiberglass substrate characterized by a high temperature resistance and a high glass transition temperature, for example, which has the glass transition temperature as high as 180-320°C. The substrate also needs to have a low dielectric constant (usually not greater than 5.0), a low moisture absorption (usually not higher than 0.4%), and a low dielectric loss (tanδ) (usually 0.005-0.03). Preferably, the substrate may be made of polyimide (PI), cyanate resin (CE), bismaleimide-triazine resin (BT), poly(phenylene ether) (PPE) or poly(phenylene oxie) (PPO). Preferably, the dielectric constant may be 2.0-3.3, the glass transition temperature may be 180-260°C. For example, a typical glass transition temperature of BT is about 210°C. Selection of these materials as substrate may satisfy the need of product processing and electrical characteristics of power LED product, and may significantly reduce the product cost for the present power LED heat-dissipating substrate.

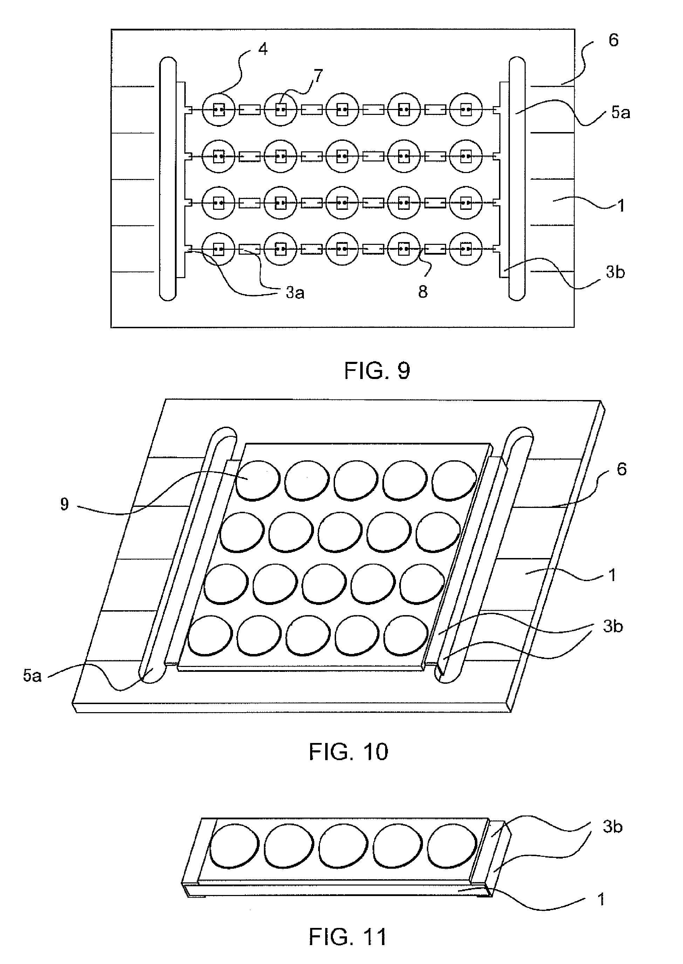

The shape of the circuit board may be determined based upon the specification of power LED, may vary in many shapes, such as rectangle, square, triangle, polygon, circle, ring, ellipse, S shape, U shape, strip, parallelogram, and heart shape etc, or any combination of those shapes. For example, FIGs. 9-13 illustrate different shapes of the substrates. Substrates of different shapes may meet the need of producing power LED of various powers, such as surface light source, strip light source, and individual component, which are beneficial for improving production yield and reducing production cost.

(S112) forming mounting hole for heat sink: position of the mounting hole may be on various locations of circuit board 1 based upon the specification of power LED product.

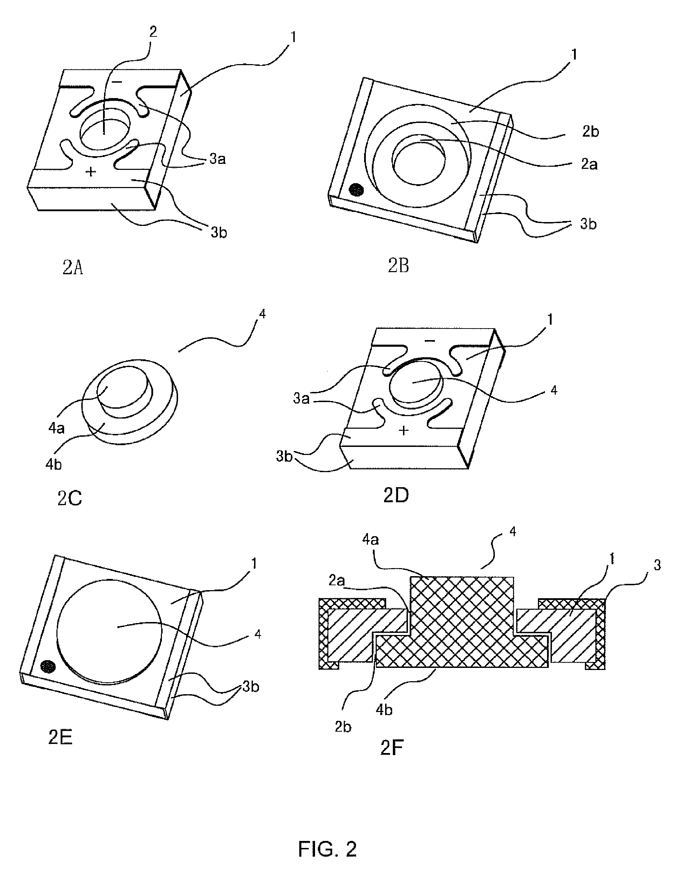

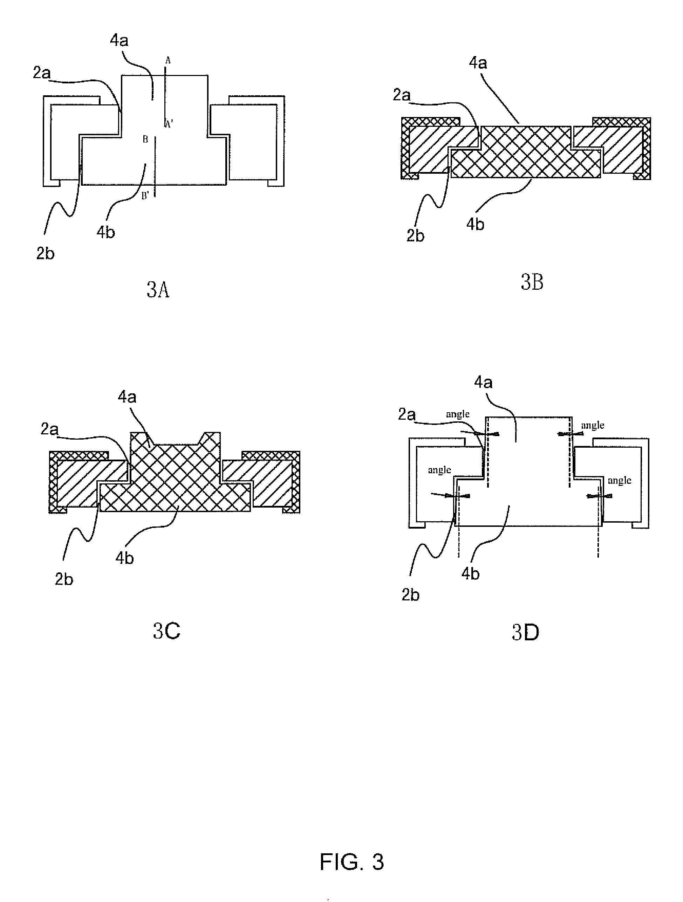

In step S 112, mounting hole for heat sink 2 includes two connected holes of different sizes, as illustrated in FIGs 2A and 2B. Preferably, small hole 2a is a through-hole formed through drilling or punching on circuit board 1, while large hole 2b is a blind-hole formed through milling or drilling. Mounting hole for heat sink 2 may be formed by first forming through-hole 2a and then forming blind-hole 2b, or by first forming blind-hole 2b then forming through-hole 2a, where both through-hole 2a and blind-hole 2b have a central axis in a common direction. The central axis of through-hole 2a and blind-hole 2b may be aligned or may not be aligned, for example, aligned as illustrated in FIG. 2F, or not aligned as illustrated in FIG. 3A. Cross-section of the through-hole or blind-hole may be a polygon. Preferably, the cross section of through-hole 2a has a circular shape or a square shape, while the cross-section of blind-hole 2b has a circular shape.

The process of forming mounting holes is simple such that the formed mounting holes are consistent. Furthermore, because of the selection of circuit board material, it is easy to vary locations and numbers of mounting holes on circuit board of various shapes based upon the need of power LED product, such that fabrication of the heat-dissipating substrate for power LED becomes simple, especially fabrication of heat-dissipating substrates for various power LED light sources.

(S113) forming metal traces: based on the formed mounting hole on circuit board, forming metal trace 3 at a corresponding location to mounting hole for heat sink 2, to have electrical connection for power LED product. Metal trace 3 includes internal trace connection 3a and external trace connection 3b, where internal trace connection 3a is a covered portion of the metal trace after packaging, and external trace connection 3b is an exposed portion of metal trace after packaging, usually as a product electrode. Preferably, a metal layer of internal trace connection 3a is formed near mounting hole for heat sink 2 and a metal layer of external trace connection 3b is formed at a relative distant location from mounting hole for heat sink 2 through etching, machining, laser processing or printing processing, such that internal trace connection 3a and external trace connection 3b are connected to form metal trace 3 to achieve the electrical connection of the product.

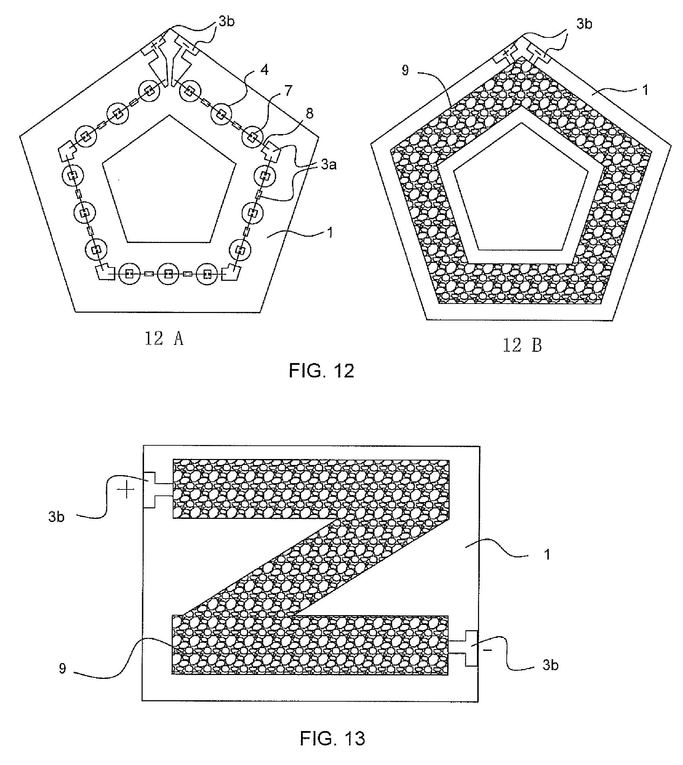

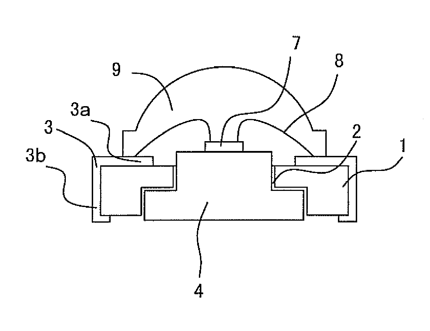

In an alternative embodiment, a metal layer of internal trace connection 3a is formed on surface of circuit board near mounting hole for heat sink 2 through etching, machining, laser processing or printing processing. Similarly, a metal layer of external trace connection 3b is formed on upper surface and lower surface of circuit board 1 at a relatively distant location from mounting hole for heat sink 2. Metallic connection between the metal layers are also formed on sides of circuit board 1, such that internal trace connection 3a and external trace connection 3b are connected to form metal trace 3 to achieve the electrical connection of the product, as illustrated in FIG. 2A and Fig. 2B. Because of the arrangement of metal trace 3, product electrode extends to a bottom of the circuit board 1 (lower surface), such that the product is suitable for surface mounting of volume production. Preferably, metal trace 3 may have various arrangements to meet the need of electrical characteristics of the power LED product, thus to achieve electrical connections of the product, including series and parallel connections, or a combination of series and parallel connections, as illustrated in FIG. 9 and FIG. 12A.

(S12) fabrication of heat sink includes steps: (S121) fabricating heat sink, (S122) polishing and cleaning, and (S123) plating.

(S121) fabricating heat sink: selecting a thermal conductive material to make heat sink 4, preferably, selecting metals of good thermal conductivity and tractility, such as copper, brass, aluminum, aluminum alloys etc.

Preferably, forming a heat sink through extrusion, metal casting, or milling based upon material properties. Heat sink 4 including upper step 4a and lower step 4b has a step cylinder-shaped structure, which has its shape and size matched to mounting hole for heat sink 2 on circuit board 1, such that heat sink 4 can be placed into mounting hole for heat sink 2 to form firm combination. Preferably, upper step 4a of the heat sink and through-hole 2a have similar diameter, while lower step 4b has a similar diameter to blind-hole 2b. Upper step 4a and lower step 4b have the same axial direction, and may be aligned (see FIG. 2F) or may not be aligned (see FIG. 3A). Upper step 4a and lower step 4b may also be perpendicular to upper and lower surface of circuit board 1. Lower step 4b may have a height greater than a depth of blind-hole 2b, as illustrated in Fig. 2F; upper step 4a of the heat sink may have a height equal or greater than a depth of through-hole 2a, as illustrated in FIGs. 2F, 3B. Preferably, upper step 4a of heat sink has a cylindrical top, which may be a plane or a concave reflection cup, as illustrated in FIGs. 3B and 3C. Preferably, upper step 4a of heat sink 4 has a slightly smaller top cross-section than a bottom cross-section, such that upper step 4a reveals a cone shape. Lower step 4b has a top cross-section slightly smaller than a bottom cross-section, such that lower step 4b reveals a cone shape, as illustrated in FIG. 3D. Thus, it is easy for assembling the heat sink and the mounting hole to form firm combination. The disclosed method ensures good contact of the lower step of the heat sink with exterior and easy for heat dissipation. Because the upper step of the heat sink is equal or higher than the circuit board or top of the circuit board, light emitting effect of the LED mounted on the circuit board is improved and ensured. Furthermore, the step structure of the heat sink allows to be easily positioned in the mounting hole of circuit board and to form a firm combination.

The disclosed method forms heat sink in various step shapes. The technique is simple, yields the heat sink with high accuracy, good consistency, and is easy to securely fit heat sink 4 in mounting hole for heat sink 2mounting hole for heat sink 2 of circuit board 1, and ensures high reliability for the heat-dissipating substrate.

(S122) polishing and cleaning: polishing formed heat sink, and cleaning the heat sink. The purpose of polishing is to smooth surface of heat sink 4 and to enhance plating effect. Polished heat sink has a reflection surface, which, when combined with plating, optimizes plating effect.

(S123) plating: after cleaning, heat sink 4 is plated. One of the purposes of plating is to increase die weldability on heat sink 4. Another purpose of plating is to form a mirror on surface of heat sink 4 to increase light reflection and thus to enhance light emitting effect of LED product.

(S13) assembling substrate and heat sink: placing heat sink 4 into mounting hole for heat sink 2 to form a firm combination, preferably through interference fit or adhesive bonding.

Because of the structural design of mounting hole for heat sink 2 and heat sink 4, heat sink 4 is easy to be positioned, and mounted, and is not easy to loosen or slip off, which solves the problems with complexity in processing, high cost, poor reliability, undesired heat dissipation, and poor light emission of the present technologies.

The disclosed method simplifies the existing process for the heat-dissipating substrate of power LED, especially for the heat-dissipating substrate of high power LED. The disclosed method reduces production cost for heat-dissipating substrate of power LED, increases heat dissipation and light emission, and ensures high quality, high reliability and yield for product.

Based upon the disclosed method, heat-dissipating substrate of power LED may be produced in various shapes. On the heat-dissipating substrate, arrangement of mounting holes and metal traces may vary to meet a particular need. The heat-dissipating substrate may be suitable for surface light source of power LED, such as in rectangle, square, triangle, polygon, circle, ring, ellipse, S shape, U shape, strip, parallelogram, Z shape, heart shape etc, or any combination, such as illustrated in FIG. 12A. The heat-dissipating substrate may also be suitable for strip light sources and individual components, as illustrated in FIG. 9. The heat-dissipating substrate has many applications, and is suitable for power LED surface light source, power LED strip light source, and individual power LED components.

To summarize, the selected circuit board is a material that is very easily processed, and at the same time satisfies the requirements of heat dissipation and electrical characteristics of power LED. According to embodiments of the present invention, shapes of circuit board may be conveniently determined based upon shapes and characteristics of power LED. Locations and numbers of mounting holes may be arranged on circuit board according to a particular need. Metal traces may be arranged to achieve electrical connections of power LED, including series connection, parallel connection, or combination of series and parallel connections. Therefore, heat-dissipating substrates for power LED surface light sources, strip light sources or individual components may be produced. The heat-dissipating substrate resolves the problems of complex structure of heat-dissipating substrates, difficult process, high production cost, poor heat dissipation and light emission for power LED surface light sources, strip light sources, and individual components.

A second embodiment for fabrication of heat-dissipating substrate of power LED, illustrated in FIGs. 4-5 and FIGs 9-10, is described below.

In this embodiment, (S4) is a fabrication method for heat-dissipating substrate 1 including multiple units of mounting hole for heat sink 2 and heat sink 4. The method includes the following steps: (S41) selecting substrate material and processing; (S42) fabricating heat sink; (S43) assembling substarte and heat sink. Among those steps, (S41) and (S42) may exchange operating sequence or occur simultaneously.

(S41) selecting substrate material and processing includes (S411) selecting substrate material, (S412) forming mounting hole, (S413) forming dividing slot or/and dividing hole, (S414) forming metal trace, (S415) forming cut position line.

(S411) selecting substrate material: selected circuit board may be a single side, a double side or multilayer composite circuit board, preferably, a double side circuit board.

In this embodiment, the characteristics of the selected substrate material, optimization method and corresponding results are similar to the first embodiment as described above, and thus the descriptions will not repeat again.

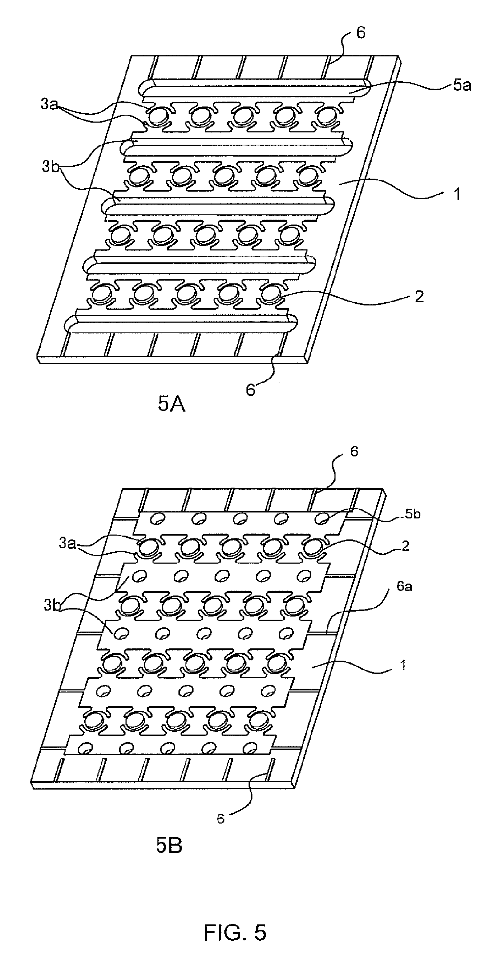

(S412) forming mounting hole: on circuit board forming an array of mounting hole for heat sink 2. Mounting hole for heat sink 2 includes a combination of blind-hole 2b of large diameter and through-hole 2a of small diameter with the same axial direction as blind-hole 2b. Preferably, through-hole 2a is through drilling or punching on circuit board 1, and blind-hole 2b is formed through milling or drilling. Mounting hole for heat sink 2 includes an array of M rows by N columns, where M, N are integers equal or greater than 1, and M and N are at least not equal to 1 simultaneously, as illustrated in FIG. 5. Circuit board 1 includes an array of 4 rows and 5 columns of mounting holes.

(S413) forming dividing slots or/and dividing holes: on substrate 1 is formed the dividing slot 5a or the dividing hole 5b, as illustrated in FIGs. 5A, 5B and 9. Preferably, dividing slots 5a or/and dividing holes 5b are placed on two sides of each row or each column of array. Alternatively, at least one dividing slot 5a or/and one dividing hole 5b are placed on the side of each mounting hole for heat sink of each mounting hole row or of each mounting hole column. Thus, there are M+1 or N+1 of dividing slots 5a or/and dividing hole 5b. Such a design is suitable for strip light sources or individual components. Preferably, the dividing slot 5a or/and dividing hole 5b has equal spacing from the corresponding mounting holes for the heat sinks of the column or row of mounting holes. Preferably, dividing slot 5b or/and/dividing hole 5b are arranged on ends of the row or column of mounting holes. Such arrangement is suitable for surface light sources or strip light sources, as illustrated in FIGs. 9-10. Alternatively, no dividing slots or/and dividing holes are arranged for surface light sources and strip light sources.

Preferably, dividing slots 5a or/and dividing holes 5b are formed through punching or milling on circuit board 1. As illustrated in FIG. 5A, through slots 5 that are through all the columns of mounting holes are placed in the middle of the rows of mounting holes. There are five through slots 5. As illustrated in FIG. 5B, dividing holes 5b are placed on the side of rows of mounting holes, and one mounting hole has at least one respective dividing hole 5b.

(S414) forming metal traces: based on the formed mounting hole on circuit board, forming metal trace 3 at a corresponding location to mounting hole for heat sink 2 to have electrical connection for power LED product. Metal trace 3 includes internal trace connection 3a and external trace connection 3b, where internal trace connection 3a is a covered portion of the metal trace after packaging, and external trace connection 3b is an exposed portion of metal trace after packaging, usually as a product electrode. Preferably, metal trace 3 is formed through etching, machining, laser processing or printing processing.

Preferably, through etching, machining, laser processing or printing processing, a metal layer of internal trace connection 3a is formed near mounting hole for heat sink 2. Internal trace connection 3a is arranged based the product need to realize electrical connections of Die 7 in series connection, parallel connections or a combination of series and parallel connections. External trace connection 3b is formed at a relatively distant location from mounting hole for heat sink 2, such that internal trace connection 3a and external trace connection 3b are connected to form metal trace 3 to realize the electrical connection of power LED.

Preferably, through etching, machining, laser processing or printing processing, a metal layer of internal trace connection 3a is formed on surface of circuit board near mounting hole for heat sink 2. A metal layer of external trace connection 3b is formed along dividing slots 5a or/and dividing holes 5b on upper surface and lower surface of circuit board 1, through etching, machining, laser processing or printing processing. Metallic connection is formed between the metal layer of upper and lower surface of circuit board and sides of dividing slots 5a or/and dividing holes 5b. The upper and lower surface near the sides of dividing slots 5a or/and dividing holes 5b and the sides of dividing slots 5a or/and dividing holes 5b form external trace connection 3b. Internal trace connection 3a and external trace connection 3b form metal trace 3 to realize electrical connections of the product.

In certain circumference, when a surface light source and a strip light source are needed, input and output of the surface light source and strip light source may be placed at their two ends. Thus, external trace connection 3b includes metal layers at a relatively distant location from mounting hole for heat sink 2 on upper surface and lower surface as well as sides of circuit board 1. External trace connection 3b and internal trace connection 3a forms metal trace 3 for the surface light source and strip light source. In this case, there may be no need to form metal trace 3 on lower surface of circuit board 1 near sides of dividing slots 5a or/and dividing holes 5b, as well as inside wall of dividing slots 5a or/and dividing holes 5b. There may be no need for arrangement of dividing slots 5a or/and dividing holes 5b.

(S415) forming cut position lines: forming cut position line 6 on ends of circuit board 1. Preferably, cut position line 6 is formed on circuit board 1 through etching, machining, laser processing or printing processing. For the heat-dissipating substrate of strip light sources, or individual components, there are multiple cut position lines 6, which are placed at ends of rows or/and columns of mounting holes, correspond to sides of rows or/and columns of mounting holes, in total, N+1 or/and M+1 of cut position lines, preferably corresponding to the middle between rows or/and columns of mounting holes. As illustrated in FIG. 5A, there are six cut position lines 6. For example, as illustrated in FIG. 5B, five cut position lines 6a are placed at end of row of mounting holes, and six cut position lines 6b are placed at end of column of mounting holes. After packaging, N or M strip light sources or N multiplied by M individual components, are formed by cutting along cut position lines 6. For instance, as illustrated in FIG. 5A, four strip light sources are formed, or 4 by 5 (20) individual components.

(S42) fabrication of heat sink includes steps: (S421) fabricating heat sinks, (S422) polishing and cleaning, and (S423) plating.

(S421) fabricating heat sinks: selecting a thermal conductive material to make heat sink 4, preferably, selecting metals of good thermal conductivity and tractility, such as copper, brass, aluminum, aluminum alloys etc, preferably formed through extrusion, metal casting or milling method.

Heat sink 4 including upper step 4a and lower step 4b has a step cylinder-shaped structure, which has a shape and size matched to mounting hole for heat sink 2 on circuit board 1, such that heat sink 4 can be placed into mounting hole for heat sink 2 to form a firm combination.

(S422) polishing and cleaning: polishing the formed heat sink, and cleaning the heat sink.

(S423) plating: after cleaning, heat sink 4 is plated. One of the purposes of plating is to increase die weldability on heat sink 4. Another purpose of plating is to form a mirror on surface of heat sink 4 to increase light reflection and thus to enhance light emitting effect of LED product.

(S43) assembling substarte and heat sink: placing heat sink 4 into mounting hole for heat sink 2, in total M by N of heat sink, heat sink 4 and mounting hole 2 form a firm combination, preferably through fit and adhesive bonding. As illustrated in FIG. 5, substarte includes 4 by 5 mounting holes 2 each placed with heat sink 4.

The above method is suitable for power LED surface light sources, strip light sources and individual LED components, especially suitable for power LED surface light sources, strip light sources and individual LED components of good heat dissipation.

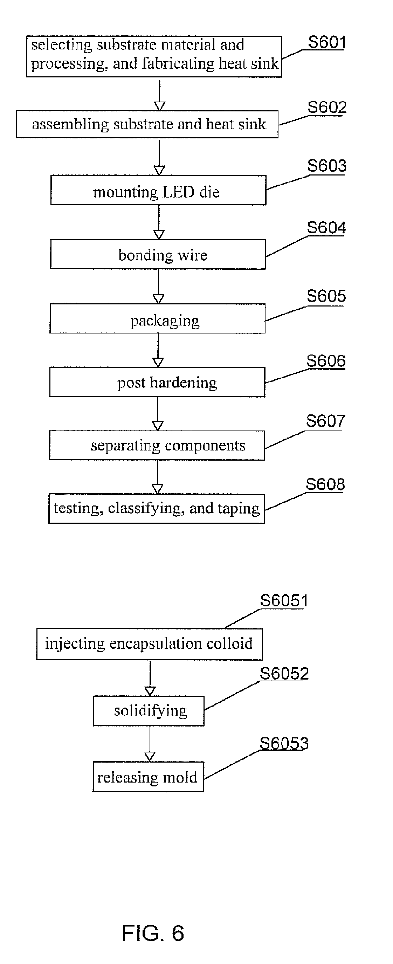

A third embodiment is based upon fabrication of the heat-dissipating substrates of power LED products in the first and second embodiments. Illustrations are given below in combination with FIGs. 6-7 and FIGs. 9-13.

In this embodiment, a fabrication method is disclosed based upon the above fabrication method of the heat-dissipating substrate of power LED, which is especially suitable for the case of low temperature solidification at a temperature lower than 260°C. The method includes the following steps: (S601) selecting substrate material and processing, and fabricating heat sink, (S602) assembling substrate and heat sink. (S603) mounting LED die, (S604) bonding wire, (S605) packaging, (S606) post hardening, (S607) separating components, and (S608) testing, classifying, and taping.

Step S601 selecting substrate material includes selecting substrate and its processing, and fabricating heat sink. Fabrication of circuit board 1 and heat sink 4 are the same as disclosed in the first and second embodiments, and will not repeat here again.

At step S602 of mounting heat sink, heat sink 4 is mounted inside mounting hole for heat sink 2 of circuit board 1 to form a firm combination by interference fitting or adhesive bonding.

At step S603 of mounting LED die, Die 7 is bonded to heat sink 4 on the heat-dissipating substrate 1 formed at step S602. Preferably, bonding may use a low temperature solidification method with solidification glue, silver paste, or low temperature solder, usually under 260°C. Furthermore, one or more dies 7 may bond to heat sink 4.

At step S604 of bonding wire, leading wire 8 connects to electrode of die 7 and internal trace connection 3a on circuit board 1. When heat sink 4 has a number of dies 7 attached, metal trace 3 may be arranged to realize electrical connections among dies 7, including series connections, parallel connections or combination of series connection and parallel connections.

Step S605 of packaging includes (S6051) injecting encapsulation colloid, (S6052) solidifying and (S6053) releasing mold. Step S6051 of injecting encapsulation colloid includes filling gaps between the mold and circuit board with liquid encapsulation colloid of good thermal stability and resistance to attenuation in short wavelength. Step 6052 of solidifying solidifies the encapsulation colloid 9 in the gaps. Step S6053 separates the mold from the substrate such that encapsulation colloid 9 fall offs the mold and fastens on circuit board 1 to complete packaging, i.e. completes the entire packaging of one or more power LED surface light sources, strip light sources or multiple individual power LED components on circuit board 1 at the same time.

Under usual circumstance, when packaging the product, the entire circuit board needs to sustain a molding clamping pressure of 0-6Mpa, an injection pressure within 5-50 Mpa, a high temperature range within 60-220°C during molding for a continuous time equal or less than 30 minutes. Preferably, molding temperature is 100-180°C for a continuous time of 5-15 minutes.

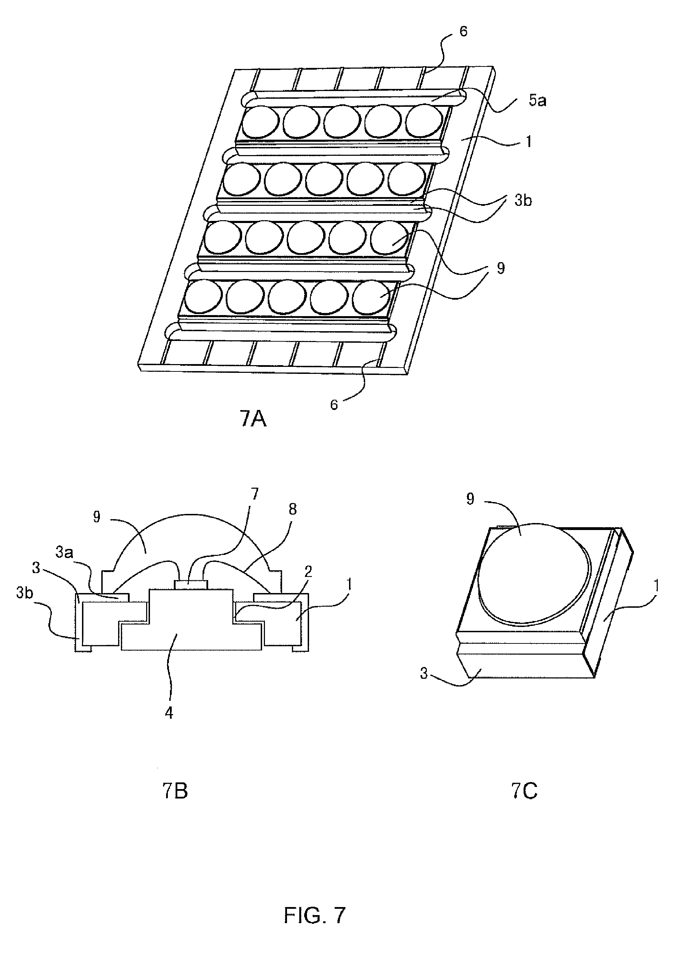

Encapsulation colloid covers one side with die 7 of circuit board 1, including covering internal trace connection 3a of metal trace 3 and keeping external trace connection 3b of metal trace 3 uncovered, as illustrated in FIGs. 7A and 7B, FIGs. 10-13. Encapsulation colloid 9 can separate die 7 and interconnection wire 8 from moisture contact and air contact. Encapsulation colloid 9 can also act as an optical lens. Preferably, the encapsulation colloid is made of material of good thermal stability and resistance to attenuation in short wavelength, particularly, silicone or silicon based material, or epoxy based material. According to specification of light emitting characteristics of power LED, the optical lens may be concave or convex, or their combination, as illustrated in FIGs. 7 and 10-13.

Step S606 post hardening places power LED with encapsulation colloid 9 into an oven to harden encapsulation colloid 9 such that glue 9 securely covers circuit board 1. For hardening, oven temperature may usually be 150±20°C and baking time may be 2.5-3.5 hours.

Step S607 of separating components utilizes a machine to cut circuit board 1 to separate power LED products. For the second example of heat-dissipating substrate, the machine cuts circuit board 1 along cut position line 6 to separate multiple strip power LED products or M x N individual power LED components. It should be mentioned here that cutting may or may not be used for surface light sources. If circuit board 1 has a number of surface light sources, cutting is necessary. Otherwise, cutting is unnecessary.

Step S608 of testing, classifying and taping uses a tester to test and classify the separated power LED products and a taping machine to package the products.

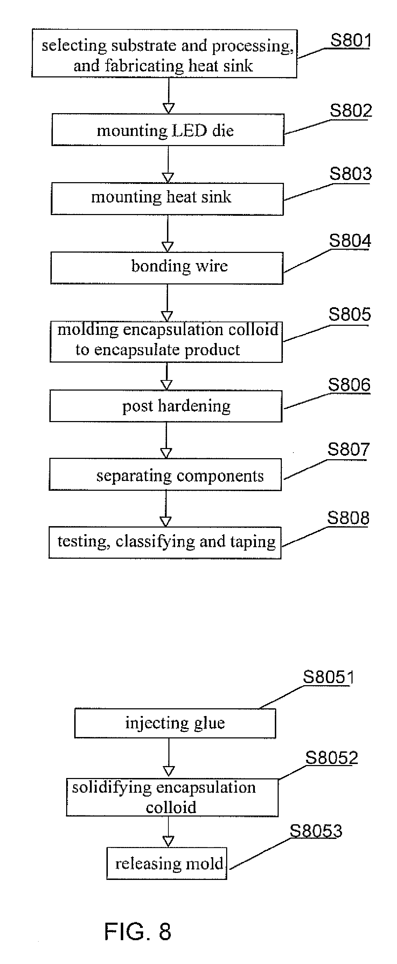

The fourth embodiment is the method of fabricating the power LED based upon the heat-dissipating substrates of the first and second embodiments. In combination with FIGs. 7-12, details are provided for the fourth embodiment.

The disclosed method for power LEDs with heat-dissipating substrates is particularly suitable for solidification at temperature greater than 260°C. The method includes (S801) selecting substrate and processing, and fabricating heat sink, (S802) mounting LED die, (S803) mounting heat sink, (S804) bonding wire, (S805) molding encapsulation colloid to encapsulate product, (S806) post hardening, (S807) separating components, and (S808) testing and classifying and taping.

Step S801 of selecting substrate and its processing and fabricating heat sink is the same as described in the first and second embodiments, and not repeated here again.

Step S802 of mounting LED die, after fabricating heat sink 4, bonding die 7 on heat sink 4. One heat sink 4 may bond to one or more dies 7. Preferably, bonding through high frequency welding, reflow welding, Eutectic welding, high temperature solidification of AnSn, usually at temperature greater than 260°C.

Step S803 of assembling substrate and heat sink, after completing mounting LED die, packaging heat sink 4 with die 7 into mounting hole for heat sink 2 of substrate 1 to form a firm combination by fitting or bonding.

Step S804 of bonding wire, connecting interconnection wire 8 to electrodes of die 7 and internal trace connection 3a on circuit board 1. It should be pointed out that if heat sink 4 has a number of dies 7, metal trace 3 may be arranged to achieve interconnections between dies 7 in series connections, parallel connections or combinations of series and parallel connections.

Sep S805 of packaging includes (S8051) injecting glue, (S8052) solidifying encapsulation colloid and (S8053) releasing mold. S8051 fills liquid encapsulation colloid 9 into the gaps between mold and circuit board 1, where liquid encapsulation colloid 9 has good thermal stability and resistance to attenuation in short wavelength. S8052 solidifies encapsulation colloid 9. S8053 separates circuit board from mold after the solidification such that encapsulation colloid 9 releases from the mold and solidifies on circuit board 1. Therefore, packaging is completed for the entire circuit board 1 having one or more power LED surface light source, power strip light source, or multiple individual power LED components at the same time.

Under usual circumstance, when packaging the product, the entire circuit board needs to sustain a mold clamping pressure of 0-6Mpa, an injection pressure within 5-50 Mpa, a high temperature range within 60-220°C during molding for a continuous time equal or less than 30 minutes. Preferably, molding temperature is 100-180°C for a continuous time of 5-15 minutes.

Encapsulation colloid 9 covers one side with die 7 of circuit board 1, including covering internal trace connection 3a of metal trace 3 and keeping external trace connection 3b of metal trace 3 uncovered, as illustrated in FIGs. 7A and 7B, FIGs. 10-13. Encapsulation colloid 9 can separate die 7 and interconnection wire 8 from moisture contact and air contact. Encapsulation colloid 9 can also act as an optical lens. Preferably, the encapsulation colloid is made of material of good thermal stability and resistance to attenuation in short wavelength, particularly, silicone or silicon based material, or epoxy based material. According to specification of light emitting characteristics of power LED, the optical lens may be concave or convex, or their combination, as illustrated in FIGs. 7 and 10-13.

Step S806 post hardening places power LED with encapsulation colloid 9 into an oven to harden encapsulation colloid 9, such that glue 9 securely covers circuit board 1. For hardening, oven temperature may usually be 150±20°C and baking time may be 2.5-3.5 hours.

Step S807 of separating components utilizes a machine to cut circuit board 1 to separate power LED products. For the second example of heat-dissipating substrate, the machine cuts circuit board 1 along cut position line 6 to separate multiple strip power LED products. For example, four strip power LED products, or at most M x N individual power LED components may be separated as illustrated in FIG. 10 and FIG. 11 . MxN individual power LED components may be separated if cutting along various cut position lines 6, or four strip power LED products are separated if cutting along the two outside cut position lines 6, as illustrated in FIG. 7C. It should be mentioned here that cutting may or may not be used for surface light sources. If circuit board 1 has a number of surface light sources, cutting is necessary. Otherwise, cutting is unnecessary.

Step S808 of testing, classifying, and taping uses a tester to test and classify the separated power LED products and a taping machine to package the products.

According to the third and fourth embodiments, various power LED products may be fabricated, such as surface light sources, strip light sources and individual components.

The surface light sources may be in various shapes, including rectangle, square, triangle, polygon, circle, ring, ellipse, S shape, U shape, strip, parallelogram, Z shape, and heart shape etc, or any combination of those shapes, as illustrated in FIGs. 10, 12 and 13. The strip light sources may be, for example, as illustrated in FIG. 11. The individual components may be, for example, as illustrated in FIG. 7C.

The power LED surface light sources, strip light sources, or individual components, where the locations and number of mounting holes 2 on the heat-dissipating substrate 1 may be arranged to meet the need of power LED and easy processing. Heat sink 4 may bond to one or more LED dies. The arrangement of metal trace 3 achieves the electrical connections of LED based upon electrical characteristics of power LED products, including series connections, parallel connections or the combination of series and parallel connections. Metal trace 3 can achieve arrangement of metal trace and placement of product electrodes, and is convenient for mounting product. Encapsulation colloid 9 covers Die 7 and a portion of metal trace 3 based upon the optical characteristics of power LED products. Encapsulation colloid 9 is a once formed optical lens, including concave, convex or combined curved lens, greatly improves light emitting effects. The structure of the product is suitable for automatic testing and taping packaging, and may be surface mounted and suitable for large-scale mounting and application.

In short, the disclosed method is simple in processing, greatly simplifies the processing of the present technology for power LED production and reduces product cost, and improves product yield. The power LED product is characterized by high reliability, good consistency, and good light emitting effect, and low cost, and is very suitable for large-scale production and application, and satisfies the present marketing need of large quantity of power LED products and greatly supports utilization of power LED products.

Having described several embodiments, it will be recognized by those skilled in the art that various modifications, alternative constructions, and equivalents may be used without departing from the spirit of the invention. The following claims intend to cover generic and specific features described herein, as well as all statements of the scope of the present method and system.

## Claims

1. A manufacturing method for heat-dissipating substrate used in power LED, comprising the following steps:
a) Forming a mounting hole on a PCB circuit board, the circuit board configured to sustain a mold clamping pressure, an injection pressure, and a molding temperature for a continuous time, the circuit board having a high glass transition temperature and shear resistance, the mounting hole comprising a through-hole of a small diameter and a blind-hole of a large diameter having the same axial direction as the through-hole;
b) Fabricating heat sink with a thermal conductive material, where the heat sink has a cylindrical shaped structure formed by an upper step and a lower step of the same axial direction as the upper step, the heat sink being matched with corresponding shape and dimension of the mounting hole.
c) Placing the heat sink into the mounting hole to form a firm combination; Step a) and step b) may exchange sequence or simultaneously occur.

2. The method of claim 1, wherein the circuit board as a whole of step a) sustains a mold clamping pressure of 0-6 Mpa and an injection pressure of 5-50 Mpa and a molding temperature of 60-200°C for a continuous time not exceeding 30 minutes, the circuit board having a glass transition temperature of at least 120°C, and the circuit board having shear resistance to obtain smooth edges after cutting a small area of a PCB unit.

3. The method of claim 2, wherein the circuit board sustains a molding temperature of 100-180°C for 5-15 minutes of molding process.

4. The method of claim 2, wherein the PCB circuit board of step a) comprises one of paper based substrate, resin fiberglass substrate and composite substrate.

5. The method of claim 2, wherein the PCB circuit board comprises a resin fiberglass substrate, wherein the substrate has a glass transition temperature of 180-300°C, a dielectric constant equal or less than 5.0, a moisture absorption equal or less than 0.4%, and a dielectric loss (tan δ) of 0.005-0.03.

6. The method of claim 5, wherein the PCB circuit board comprises one of polyimide (PI), cyanate resin (CE), bismaleimide-triazine resin (BT), poly(phenylene ether) (PPE) or poly(phenylene oxie) (PPO).

7. The method of claim 1, wherein the shape of the PCB circuit board comprises one of rectangle, square, triangle, polygon, circle, ring, ellipse, S shape, U shape, strip, parallelogram, Z shape, and heart shape or a combination of these shapes.

8. The method of claim 1, wherein the step a) of forming mounting hole comprises forming blind-hole through milling or drilling, forming through-hole through drilling or punching; forming metal traces on the circuit board comprising the steps of forming internal trace connection and forming external trace connection.

9. The method of claim 8, wherein step a) comprises forming metal traces on the circuit board through one of etching, machining, laser processing or printing.

10. The method of claim 8, whereinstep a) comprises forming internal trace connection near the mounting hole on upper surface of the PCB circuit board, forming a first portion metal layer of external trace connection at a relative distant location from the mounting hole on upper and lower surfaces of the PCB circuit board, forming a second portion metal layer on sides of the PCB circuit board through metal processing, connecting the first portion and second portion to form the external trace connection, such that the internal trace connection and external trace connection are combined to form metal trace to achieve the electrical connection of the product.

11. The method of claim 1, wherein the step b) comprises a step of plating the heat sink.

12. The method of claim 11, wherein the step b) comprises polishing and cleaning the heat sink prior to the plating.

13. The method of claim 1, wherein the thermal conductive material in the step b) comprises one of copper, brass, aluminum, and aluminum alloy.

14. The method of claim 1, wherein the step c) of mounting heat sink into mounting hole comprises forming a firm combination of the heat sink and the mounting hole by interference fitting or bonding.

15. The method of claim 1, wherein the upper step has a height equal or greater than a depth of the through-hole, the lower step has a height equal or greater than a depth of the blind-hole, wherein a central axis of the upper step is aligned or not aligned with a central axis of the lower step;
forming a top surface on the upper step as a plane or a reflective concave cup;
wherein a top cross section of the upper step is slightly smaller than a bottom cross section of the upper step such that the upper step is in a cone shape, wherein a top cross section of the lower step is slightly smaller than a bottom cross section of the lower step such that the lower step is in a cone shape;
wherein the through-hole of the mounting hole of the circuit board has a cross section in a circular shape, square shape or polygon shape, wherein the blind-hole has a circular cross section.

16. The method of any of claims 1-15, whreien the step a) comprises arranging an array of M x N of mounting holes for heat sinks on the PCB circuit board, wherein M, N are integer equal or greater than 1, and M and N at least do not simultaneously equal to 1.

17. The method of claim 16, wherein the step a) comprises forming at least one dividing slot or dividing hole on a side of at least one row or column of mounting holes.

18. The method of claim 16, wherein the step a) comprises forming at least one dividing slot or dividing hole on a side of at least one row or column of mounting holes, and forming at least one dividing slot or dividing hole on a side of each mounting hole of each row or column of mounting holes.

19. The method of claim 17 or 18, wherein the step of forming metal trace comprises through one of etching, machining, laser processing or printing, forming a metal layer of internal trace connection on upper surface of the PCB circuit board near mounting hole, forming a first portion metal layer of external trace connection along dividing slots or/and dividing holes on upper surface and lower surface of circuit board, through metal processing along sides of dividing slots or/and dividing holes forming a second portion metal layer connected to the first portion metal layer on the upper and lower surface of the circuit boardand , such that the internal trace connection and external trace connection are combined to form metal trace to achieve the electrical connection of the product.

20. The method of claim 16, wherein the step a) comprises forming dividing slot or/and dividing hole through punching, drilling or milling.

21. The method of claim 16, wherein the step a) comprises forming cut position line on ends of the circuit board, wherein the cut position line is located on two ends of a row of mounting holes or/and a column of mounting hole and corresponding to side of row of mounting holes or column of mounting holes.

22. The method of claim 21, wherein forming cut position line is through one of etching, machining, laser processing or printing processing.

23. The method of claim 21, wherein dividing slots or/and dividing holes are arranged to have equal distance from adjacent column of mounting holes or/and row of mounting holes, wherein the cut position line is in the middle between respective neighboring row or/and column of mounting holes.

24. A method for fabrication of power LED based upon PCB circuit board, comprising the method of manufacturing heat-dissipating substrate of claims 1-23, comprising the following steps:
1) Selecting mounting a LED die on a heat sink under one of high temperature solidification or low temperature solidification;
High temperature solidification: step b) comprising bonding the LED die on the heat sink under high temperature;
Low temperature solidification: after step c) bonding the LED die on the heat sink under low temperature;
2) Forming connection: after step c) connecting electrodes of the LED die with metal traces on the circuit board.

25. The method of claim 24, wherein the low temperature is below 260°C, bonding the die on the heat sink by using a solidification glue, silver paste or low temperature solder, wherein the high temperature is above 260°C, bonding the LED die on the heat sink through high frequency welding, reflow welding, Eutectic welding, high temperature solidification of AnSn.

26. The method of claim 24 or 25, the packaging step comprising 1) step of injecting encapsulation colloid: injecting liquid encapsulation colloid into gaps between a mold and the circuit board, transforming liquid encapsulation colloid into an optical lens covering one side of the circuit board having the LED die; 2) step of solidification: solidifying the liquid encapsulation colloid; 3) step of releasing mold, separating the mold from the circuit board after solidification, the encapsulation colloid separating from the mold and sticking on the circuit board.

27. The method of claim 26, wherein the encapsulation colloid forms the optical lens and covers the die and the internal trace connection of the heat-dissipating substrate and retains the external trace connection uncovered.

28. The method of claim 27, wherein the encapsulation colloid comprises a material of good thermal conductivity and resistance to attenuation in short wavelength, including one of silicone, or silicone based material, and epoxy based material.

29. The method of claim 26, wherein the temperature range for the packaging is 60-220°C for a time of equal or less than 30 minutes.

30. The method of claim 26, wherein the molding temperature range for the packaging is 100-180°C for a molding time of equal or less than 5-15 minutes.

31. The method of claim 26, further comprising post hardening at a temperature of 150±20°C for a time period of 2.5-3.5 hours.

32. The method of claims 24, 25, further comprising connecting the electrode of the LED die to the internal trace connection on the circuit board to achieve electrical connections between the LED die and the circuit board.

33. The method of claim 26, wherein the optical lens comprises one of concave, convex, and a lens of curved surface.

34. The circuit board fabricated by the method of claims 1-23.

35. The power LED product fabricated by the method of claims 24-34.

36. A light source including the characteristics of the power LED of claim 35.

37. The light source of claim 36, wherein the light source comprises one of surface light source, strip light source, and individual components.
